# EUROPEAN PATENT SPECIFICATION

(11) **EP 1 596 418 B1**
(45) Date of publication and mention of the grant of the patent: **27.07.2011**
(21) Application number: 04711692.6
(22) Date of filing: 17.02.2004
(51) Int. Cl.: H01J 37/073, H01J 9/04, H01J 1/16, H01J 37/063, H01J 37/075

(54) **ELECTRON GUN**
ELEKTRONENKANONE
CANON À ELECTRONS

(30) Priority: 17.02.2003 JP 2003037920
(43) Date of publication of application: 16.11.2005
(73) Proprietor: DENKI KAGAKU KOGYO KABUSHIKI KAISHA, Chiyoda-ku, Tokyo 100-8455 (JP)
(72) Inventor: TERUI, Yoshinori c/o Denki Kagaku Kogyo K.K., Shibukawa-shi, Gunma 3778520 (JP); NONOGAKI, Ryozo c/o Denki Kagaku Kogyo K.K., Shibukawa-shi, Gunma 3778520 (JP); SAKAWA, Seiichi c/o Denki Kagaku Kogyo K.K., Shibukawa-shi, Gunma 3778520 (JP)
(74) Representative: Hartz, Nikolai
(86) International application number: PCT/JP2004/001686
(87) International publication number: WO 2004/073010

(56) References cited:
- JP-A- 8 036 981
- JP-A- 8 222 163
- JP-A- 56 082 539
- JP-A- 2000 021 288
- JP-A- 2001 325 910
- JP-A- 2001 343 733
- JP-A- 2002 216 687
- JP-A- 2003 324 050
- JP-B2- 6 019 959
- US-A- 3 947 716

## Description

### TECHNICAL FIELD

The present invention relates to an electron gun to be used for an electron beam-applied instrument such as a scanning electron microscope, an Auger electron spectroscope, an electron beam lithography machine or a wafer inspection apparatus, particularly to an electron gun suitable for an electron beam lithography machine.

### BACKGROUND ART

In recent years, in order to obtain an electron beam having a longer life time and higher brightness than a thermionic cathode, an electron gun has been used which employs a cathode said to have a covering layer of zirconium and oxygen formed on a needle electrode made of tungsten single crystal (hereinafter referred to as a ZrO/W electron gun) (D. Tuggle, J. Vac. Sci. Technol. 16, p. 1699 (1979)).

The ZrO/W electron gun is one wherein a covering layer comprising zirconium and oxygen (hereinafter referred to as a ZrO covering layer) is formed on a needle cathode of tungsten single crystal having an axial orientation being <100> orientation. By such a ZrO covering layer, the work function of the (100) crystallographic plane of tungsten single crystal is reduced from 4.5 eV to about 2.8 eV, and only the very small crystallographic facet corresponding to the (100) crystallographic plane formed at the apex of the cathode becomes an electron emission area, whereby an electron beam having a higher brightness than by a conventional thermionic cathode can be obtained, and the electron gun has a characteristic such that it has a long life time. Further, it has characteristics such that it is more stable than a cold field emission electron source and is operable even with a high pressure and easy to use (M. J. Fransen, "On the Electron-Optical Properties of the ZrO/W Schottky Electron Emitter", ADVANCES IN IMAGING AND ELECTRON PHYSICS, VOL. III, p. 91-166, 1999 by Academic Press).

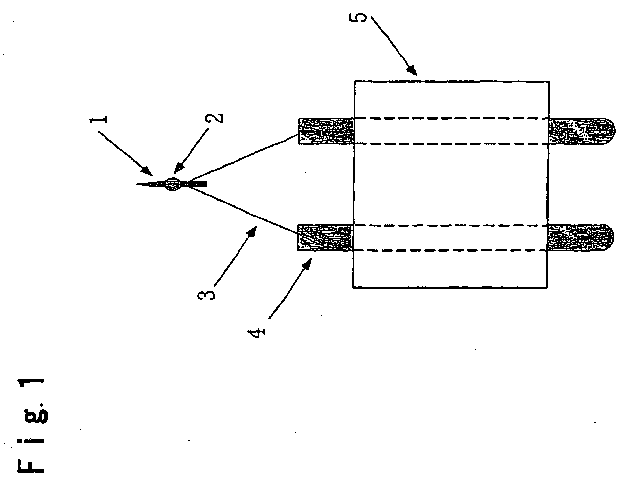

As shown in Fig. 1, in the ZrO/W electron gun, a tungsten needle cathode 1 having <100> orientation which emits an electron beam, is fixed by e.g. welding to a predetermined position of a tungsten filament 3 provided on conductive terminals 4 fixed to an insulator 5. A zirconium- and oxygen-supply source 2 is formed at a portion of the cathode 1. Although not shown in the drawings, the surface of the cathode 1 is covered with a ZrO covering layer.

The cathode 1 is Joule heated by the filament 3 and used usually at a temperature of about 1,800 K. Accordingly, the ZrO covering layer on the surface of the cathode 1 will be evaporated. However, from the supply source 2, zirconium and oxygen will diffuse and will be continuously supplied to the surface of the cathode 1, and consequently, the ZrO covering layer will be maintained.

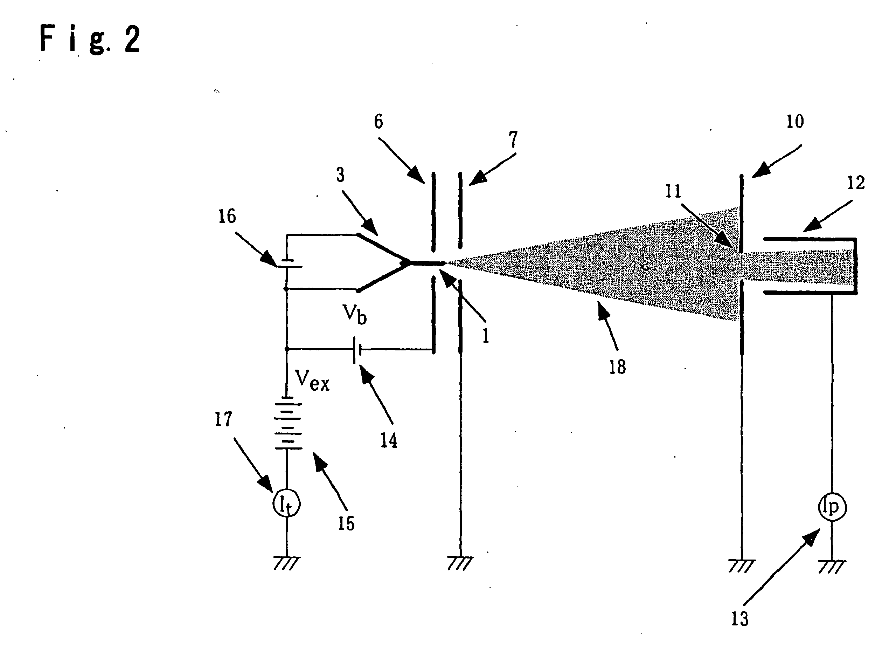

The ZrO/W electron gun is used so that the forward end of the cathode 1 is disposed between a suppressor 6 and an extractor 7 (see Fig. 2). To the cathode 1, a negative high voltage against the extractor 7 is applied, and to the suppressor 6, a voltage negative by about a few hundreds volt against the cathode 1 is applied, to suppress thermionic electrons from the filament 3.

In a CD-SEM or a wafer inspection apparatus which is used at a low acceleration voltage, the ZrO/W electron gun is operated at an angular intensity of from 0.1 to 0.2 mA/sr for such a reason that the probe current is thereby stable and the energy spread can be suppressed.

On the other hand, in an electron beam lithography machine, an Auger electron spectroscope or the like, an electron gun is operated at a high angular intensity of about 0.4 mA/sr, since the throughput is thereby of importance. In such an application where the throughput is of importance, operation at a still higher angular intensity is desired, and in some cases, operation at an angular intensity as high as 1.0 mA/sr may be required.

However, with the ZrO/W electron gun, (1) in high angular intensity operation, an angular intensity at a level of 1.0 mA/sr is the upper limit, and (2) at that time, the extractor voltage to be applied between the cathode and the extractor is as high as at least 4 kV, and the field strength at the apex of chip will be very high at a level of from 0.4 to 1.0×10⁹ V/m, whereby frequency of troubles due to arcing will be high (D. W. Tuggle, J. Vac. Sci. Technol. B3(1), p. 220 (1985)).

In order to overcome such drawbacks, an electron gun has been proposed which is an electron gun comprising a cathode 1, a suppressor 6 and an extractor 7, wherein the cathode 1 is made of a rare earth hexaboride, and its apex is disposed between the suppressor 6 and the extractor 7 (JP-A-2001-325910).

The ZrO/W electron gun has problems such that (1) in high angular intensity operation, an angular intensity at a level of 1.0 mA/sr is the upper limit, and (2) at that time, the extractor voltage to be applied between the cathode and the extractor is as high as at least 4 kV, and the field strength at the apex of chip will be very high at a level of from 0.4 to 1.0×10⁹ V/m, whereby frequency of troubles due to arcing will be high.

The electron gun employing a cathode of a rare earth hexaboride to solve such problems, has a drawback that the characteristics will change with the operation time such that the hexaboride will react with the residual oxygen in vacuum and will be consumed by oxidation, whereby the shape of the electron emission portion will be changed (P. R. Davis, J. Vac. Sci. Technol, B4(1), p. 112 (1986), H. Hagiwara, SCANNING ELECTRODE MICROSCOPE, II, p. 473 (1982), SEM Inc.).

Further, a lanthanum hexaboride thermionic cathode has a drawback such that the electron emission surface tends to be roughened by ion bombardment, and in an extreme case, the shape of the electron emission portion will be changed, whereby ripples will appear in the angle distribution of electron beams, and the uniformity on the electron beam irradiation surface will be deteriorated. Under these circumstances, the life time of an electron gun employing a rare earth hexaboride cathode is at a level of a few months.

Further, an electron gun comprising a cathode 1, a suppressor 6 and an extractor 7, characterized in that the cathode 1 is made of a rare earth hexaboride, and its apex is disposed between the suppressor 6 and the extractor 7, has a problem that the surplus current is substantial.

### DISCLOSURE OF THE INVENTION

Under the above circumstances, the present inventors have conducted various studies, and as a result, have solved the above problems and have arrived at the present invention.

Namely, the present invention provides an electron gun provided with a cathode which comprises a single crystal needle (or rod) of tungsten or molybdenum and a supply source to diffuse at least one metal element selected from the group consisting of Groups 2A, 3A and 4A of the periodic table, formed on the needle, wherein an apex of the cathode has a truncated cone shape the truncation providing a flat portion, and the truncated cone shape portion has a cone angle of from 25° to 95° and a diameter of said flat portion of from 5 µm to 200 µm. In the electron gun of the present invention, the diameter of the top surface of the truncated cone is preferably from 50 µm to 200 µm, the metal element is preferably zirconium or titanium, and the <100> orientation of the single crystal constituting the cathode and the direction normal to the top surface are preferably within an angle difference of not more than 2°.

Further, the present invention provides a process for producing such an electron gun which comprises forming an end of a single crystal into a cone shape by mechanical polishing or electrolytic polishing and then removing the forward end of the cone flatly by mechanical polishing or focused gallium ion beam to form a truncated cone shape. In the process for producing an electron gun of the present invention, forming into a truncated cone shape is preferably carried out by a focused gallium ion beam in a xenon difluoride gas atmosphere.

### BRIEF DESCRIPTION OF THE DRAWINGS

Fig. 1 is a structural view of a ZrO/W electron gun.
Fig. 2 is a structural view of an apparatus for evaluating electron emission characteristics.

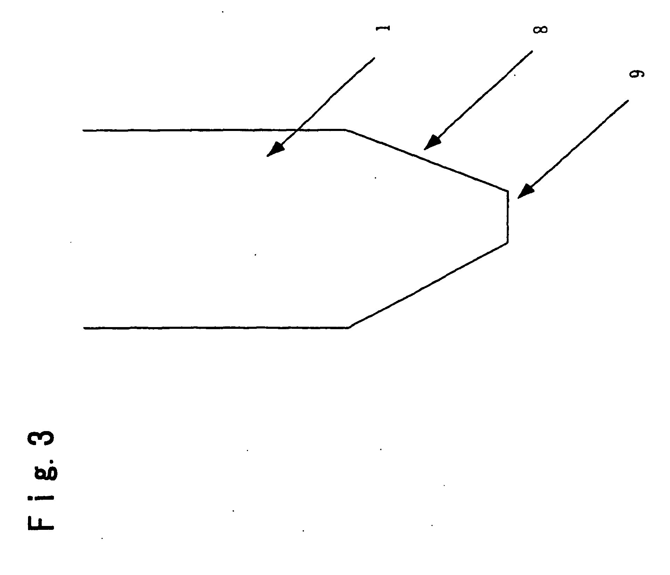

Fig. 3 is an enlarged view of a cathode.
Fig. 4 shows the results of measurement of extractor voltage-angular intensity, and extractor voltage-total emission current (Example 1 and Comparative Example).

### MEANINGS OF SYMBOLS

1: Cathode
2: Supply source
3: Filament
4: Conductive terminal
5: Ceramics insulator
6: Suppressor
7: Extractor
8: Cone portion (of truncated cone)
9: Flat portion (top surface portion of truncated cone)
10: Phosphorous screen
11: Aperture
12: Cup-shaped electrode
13: Electric current ammeter for measuring probe electric current
14: Bias power source
15: High voltage power source
16: Filament-heating power source
17: Ammeter for measuring total emission current
18: Emitted electron beam

### BEST MODE FOR CARRYING OUT THE INVENTION

A specific embodiment of the present invention is one wherein at an end of a rod-shaped cathode 1 of tungsten or molybdenum single crystal having <100> orientation, a cone portion 8 is formed by mechanical polishing or electrolytic polishing, and further its apex is polished by a polishing film coated with a diamond abrasive or the apex is cut by means of a focused gallium ion beam device, to provide a flat portion 9.

In the present invention, the processing time can be shortened by introducing xenon difluoride gas during the processing with a focused gallium ion beam. Further, the total angle of the cone portion 8 is from 25° to 95°, and the diameter of the flat portion 9 (or the top surface portion) is from 5 to 200 µm. Further, the normal line to the flat electron emission surface formed at the end of the cathode 1 is preferably within an angle difference of not more than 2°, preferably not more than 0.5°, from the <100> orientation.

The rod of tungsten or molybdenum single crystal having <100> orientation will function as a cathode and is provided with a supply source to diffuse at least one metal element selected from the group consisting of Group 2A (such as Be, Mg, Ca, Sr and Ba), Group 3A (such as Sc, Y, lanthanoid elements and actinoid elements) and Group 4A (such as Ti, Zr and Hf) of the periodic table (long-period type). If a Zr-O system is taken as an example, zirconium hydride is pulverized and mixed with an organic solvent to form a paste, which is applied to a portion of a cathode, and the cathode is heated in an oxygen atmosphere at a level of 1×10⁻⁶ Torr to thermally decompose ZrH₂, followed by further oxidation to form a supply source of zirconium and oxygen.

Such a cathode is disposed between the extractor 7 and the suppressor 6, and a negative high voltage of a few kV is applied to the cathode 1 against the extractor 7. To the suppressor 6, a negative voltage of a few hundreds V is applied against the cathode 1, and the at the same time, the cathode 1 is heated at a temperature of from 1,500 to 1,900 K, so that electron emission can be carried out.

The electron gun of the present invention is operable at a high angular intensity of at least 1 mA/sr and is highly reliable since the total emission current is low at a level of a few tens µA, and the surplus current is very low. Further, this electron gun is also operable in vacuum of at most 1×10⁻⁸ Torr, and consumption of the cathode is extremely small, and a change in the characteristics is little, even during operation for a long period of time, since tungsten is the base material, and it further has a characteristic such that even if the cathode surface is roughened by ion bombardment, it will immediately be restored to a smooth surface.

### EXAMPLES

### EXAMPLES 1 and 2 and COMPARATIVE EXAMPLE

A tungsten filament 3 was fixed by spot welding to conductive terminals 4 fixed to ceramics insulator 5. At an end of single crystal tungsten chip having <100> orientation, a cone portion 8 having a total angle of 90° was formed by means of a diamond paste and a grinder, and further, the apex of the cone portion was polished with a polishing film coated with a diamond abrasive to form a flat portion 9 having a diameter of 100 µm. This rod was attached to the above filament by spot-welding. This rod functions as a cathode 1.

Zirconium hydride was pulverized and mixed with isoamyl acetate to form a paste, which was applied to a portion of the cathode 1. After evaporation of isoamyl acetate, the cathode was introduced into an apparatus shown in Fig. 2.

The apex of the cathode 1 is disposed between the suppressor 6 and an extractor 7. Here, the distance between the apex of the cathode 1 and the suppressor 6 is 0.15 mm, the distance between the suppressor 6 and the extractor 7 is 0.8 mm, and the aperture diameter of the extractor 7 is 0.8 mm, and the aperture diameter of the suppressor 6 is 0.8 mm.

The filament 3 is connected to a filament heating power source 16 and further connected to a high voltage power source 15, whereby a negative high voltage against the extractor 7, i.e. the extractor voltage Vₑₓ, is applied. Further, the suppressor 6 is connected to a bias power source 14, and a further negative voltage i.e. bias voltage Vb, against the cathode 1 and the filament 3, is applied. Thermionic electron emitted from the filament 3 will thereby be shielded. The total emission current It from the electron source is measured by an ammeter 17 disposed between the high voltage power source 15 and an earth. The electron beam (emitted electron beam) 18 emitted from the apex of the cathode 1 will pass through an aperture of the extractor 7 and reach a phosphorous screen 10. At the center of the phosphorous screen 10, there is an aperture 11 (a small pore), and a probe electric current Ip passed through the aperture and reached a cup-shaped electrode 12, will be measured by a minute electric current ammeter 13. Further, when a solid angle calculated from the distance between the aperture 11 and the apex of the cathode 1 and the inner diameter of the aperture 11, is represented by ω, the angular intensity will be Ip/ω.

Then, the interior of the apparatus was brought to an ultrahigh vacuum of 3×10⁻¹⁰ Torr (4×10⁻⁸ Pa), whereupon an electric current was conducted to the filament 3 to heat the cathode 1 at 1,800 K thereby to thermally decompose ZrH₂ and convert it to metal zirconium. Further, oxygen gas was introduced to bring the interior of the apparatus to be 3×10⁻⁶ Torr (4×10⁻⁴ Pa) thereby to oxidize metal zirconium to form a supply source of zirconium and oxygen.

The interior of the apparatus was again brought to an ultrahigh vacuum of 3×10⁻¹⁰ Torr (4×10⁻⁸ Pa), and the while the cathode was maintained at 1,700 K or 1,800 K, a bias voltage V_{b}=300 V was applied to the suppressor, and then, a high voltage of the extractor voltage Vₑₓ=1 kV was applied and maintained for a few hours, whereby when the emission current was stabilized, the total emission current It and the probe current Ip were measured, and the angular intensity was calculated.

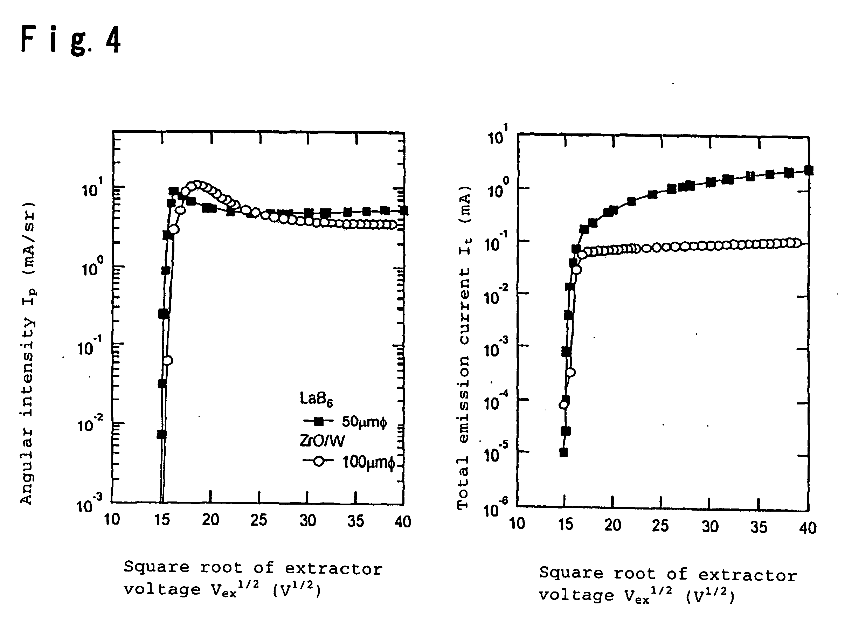

The results are shown in Table 1, and examples of measurement of the extractor voltage-angular intensity and the extractor voltage-total emission current, at the time of 1,700 K, are shown in Fig. 4. Further, using a lanthanum hexaboride single crystal cathode having <100> orientation, the electron emission characteristics were measured in the same manner as disclosed in JP-A-2001-325910, and taken as a Comparative Example. The cone angle of the cathode was 60°. The diameter of the flat portion was 50 µm.

**TABLE 1**

| | Type of cathode | Extractor voltage | Operation temperature | Operation angular intensity (mA/sr) | Total emission current |
|---|---|---|---|---|---|
| Ex. 1 | ZrO/W 100 µm 90° | 1 kV | 1, 700 K | 3.5 | 90 µA |
| Ex. 2 | ZrO/W 100 µm 90° | 1 kV | 1,800 K | 5.0 | 137 µA |
| Comp. Ex. | LaB₆ 50 µm 60° | 1 kV | 1,700 K | 4.7 | 1.6 mA |

### INDUSTRIAL APPLICABILITY

The electron gun of the present invention is operable at an angular intensity of a level substantially equal to Comparative Example, and the total emission current at that time is smaller by at least one figure than Comparative Example. Thus, it is apparent that the electron gun of the present invention has high reliability. Further, while a conventional ZrO/W electron gun has an operation angular intensity of 1 mA/sr at best, the electron gun of the present invention has a characteristic that at a low extractor voltage of 1 kV, an emission current having a high operation angular intensity at a level of from 3 to 5 mA/sr can be obtained, and thus, it is useful as various electron sources including an electron source for an electron beam lithography machine.

Further, according to the process for producing an electron gun of the present invention, it is possible to present such an electron gun having the above-mentioned characteristics with good reproducibility and accordingly inexpensively, and thus it is industrially very useful.

## Claims

1. An electron gun provided with a cathode which comprises a single crystal needle (1) of tungsten or molybdenum and a supply source to diffuse at least one metal element selected from the group consisting of Groups 2A, 3A and 4A of the periodic table, formed on the needle, wherein an apex of the cathode has a truncated cone shape (8), the truncation providing a flat portion (9) and the truncated cone shape portion has a cone angle of from 25° to 95° and a diameter of said flat portion of from 5 µm to 200 µm.

2. The electron gun according to Claim 1, wherein the diameter of said flat portion of the truncated cone is from 50 µm to 200 µm.

3. The electron gun according to Claim 1 or 2, wherein the metal element is zirconium or titanium.

4. The electron gun according to Claim 1, 2 or 3, wherein the <100> orientation of the single crystal constituting the cathode and the direction normal to the top surface are within an angle difference of not more than 2°.

5. A process for producing an electron gun as defined by claim 1, or electrolytic polishing and then removing the forward end of the cone flatly by mechanical polishing or focused gallium ion beam to form a truncated cone shape.

6. The process for producing an electron gun according to Claim 5, wherein forming into a truncated cone shape is carried out by a focused gallium ion beam in a xenon difluoride gas atmosphere.

## Patentansprüche

1. Elektronenkanone mit einer Kathode, die eine Einkristallnadel (1) aus Wolfram oder Molybdän umfasst sowie eine Versorgungsquelle, die auf der Nadel ausgebildet ist, um mindestens ein Metallelement, ausgewählt aus den Gruppen 2A, 3A und 4A des Periodensystems zu verteilen, wobei eine Spitze der Kathode eine Form eines Kegelstumpfes (8) aufweist und der Stumpf einen flachen Bereich (9) bereitstellt und der Bereich des Kegelstumpfes einen Kegelwinkel von 25° bis 95° aufweist sowie einen Durchmesser des flachen Bereichs von 5 µm bis 200 µm.

2. Die Elektronenkanone nach Anspruch 1, wobei der Durchmesser des flachen Bereichs des Kegelstumpfes im Bereich von 50 µm bis 200 µm liegt.

3. Die Elektronenkanone nach Anspruch 1 oder 2, wobei das Metallelement Zirkonium oder Titan ist.

4. Die Elektronenkanone nach einem der Ansprüche 1, 2 oder 3, wobei die <100> Orientierung des Einkristalls, der die Kathode aufbaut sowie die Richtung, die normal auf der oberen Oberfläche steht innerhalb einer Winkeldifferenz von nicht mehr als 2° vorliegen.

5. Verfahren zur Herstellung einer Elektronenkanone, wie sie in Anspruch 1 definiert wird, das umfasst eine Ausbildung eines Endes eines Einkristalls in eine Kegelform durch mechanisches Polieren oder elektrolytisches Polieren und anschließend Abflachen des Kegels durch mechanisches Polieren oder fokussierten Gallium-lonen-Strahl, um einen Kegelstumpf auszubilden.

6. Das Verfahren zur Herstellung einer Elektronenkanone nach Anspruch 5, wobei die Ausbildung eines Kegelstumpfes durchgeführt wird durch einen fokussierten Gallium-lonen-Strahl in einer Xenondifluorid-Gasatmosphäre.

## Revendications

1. Canon à électrons pourvu d'une cathode qui comprend une aiguille monocristalline (1) en tungstène ou en molybdène et une source d'alimentation formée sur l'aiguille pour diffuser au moins un élément métallique choisi parmi le groupe constitué des groupes 2A, 3A et 4A du tableau périodique, dans lequel un sommet de la cathode présente une forme de cône tronqué (8), la partie tronquée formant une partie plate (9) et la partie conique tronquée présentant un angle de conicité de 25° à 95° et un diamètre de ladite partie plate de 5 µm à 200 µm.

2. Canon à électrons selon la revendication 1, dans lequel le diamètre de ladite partie plate du cône tronqué est de 50 µm à 200 µm.

3. Canon à électrons selon la revendication 1 ou 2, dans lequel l'élément métallique est le zirconium ou le titane.

4. Canon à électrons selon la revendication 1, 2 ou 3, dans lequel l'orientation <100> du monocristal constituant la cathode et la direction normale à la surface supérieure sont dans une différence angulaire non supérieure à 2°.

5. Procédé pour produire un canon à électrons tel que défini par la revendication 1, lequel procédé comprend la mise en forme de cône d'une extrémité d'un monocristal par polissage mécanique ou polissage électrolytique et ensuite le retrait de l'extrémité avant du cône de manière plate par un polissage mécanique ou un faisceau d'ions de gallium focalisé pour former une forme de cône tronqué.

6. Procédé pour produire un canon à électrons selon la revendication 5, dans lequel la mise en forme de cône tronqué est mise en oeuvre par un faisceau d'ions de gallium focalisé dans une atmosphère de gaz de difluorure de xénon.
